# EUROPEAN PATENT SPECIFICATION

(11) **EP 4 597 153 B1**
(45) Date of publication and mention of the grant of the patent: **04.11.2026**
(21) Application number: 22964811.8
(22) Date of filing: 10.11.2022
(51) Int. Cl.: G01S 7/40, G01R 35/00

(54) **ZERO-PHASE CALIBRATION METHOD, COMPUTER DEVICE, AND STORAGE MEDIUM**
NULLPHASENKALIBRIERVERFAHREN, COMPUTERVORRICHTUNG UND SPEICHERMEDIUM
PROCÉDÉ D'ÉTALONNAGE DE PHASE NULLE, DISPOSITIF INFORMATIQUE ET SUPPORT D'ENREGISTREMENT

(43) Date of publication of application: 06.08.2025
(73) Proprietor: Tunkia Co., Ltd., Changsha, Hunan 410100 (CN)
(72) Inventor: ZHOU, Xinhua, Changsha, Hunan 410100 (CN)
(74) Representative: Santarelli
(86) International application number: PCT/CN2022/131224
(87) International publication number: WO 2024/098342

(56) References cited:
- CN-A- 102 136 858
- CN-A- 105 607 022
- CN-A- 105 607 022
- CN-A- 110 031 811
- CN-A- 111 289 950
- CN-A- 113 820 642
- CN-B- 104 237 622
- CN-U- 203 101 619
- US-A- 3 597 636
- US-A- 4 937 535
- US-A- 4 937 535
- US-A1- 2003 042 886
- US-B1- 10 145 930

## Description

### Technical field

The present application relates to the field of phase calibration. Specifically, the present application relates to a zero-phase calibration method, computer device and storage medium.

### Background

Wide-range meters such as vector voltage analyzers combined with voltage or current range extenders, can realize multi-channel voltage or current ratio measurement, phase difference measurement and realize power measurement function with combined voltage and current channels, etc. Such types of meters usually need to be calibrated on effective values of channel voltage/current and inter-channel phase difference error before use, so as to ensure measurement accuracy thereof. Presently, calibration of channel phase difference of vector voltage analyzers and other multi-channel measuring meters, such as phase meters, generally uses a high precision signal source with high stability and low noise, which is adjustable on amplitude and frequency, utilizing the means of a voltage divider or shunt to calibrate zero-phase points directly. Due to the numerous channels and measurement ranges of a wide-range meter, there are a plurality of range combinations that need to be calibrated. Current calibration methods mostly utilize the way of manual calibration, which is inefficient, with low-precision and long calibration duration. Some automatic calibration methods require to scan all combinations of ranges, resulting in very time-consuming calibration process.

In addition, when a wide-range meter measures with a combination of a large-range and a small-range having a wide span between different channels, due to the need to introduce a voltage divider or shunt to obtain a small amplitude signal and input it into the channel with the small range for initial calibration, such calibration methods cannot achieve high-precision phase quantitative dissemination as the limitation of phase-frequency characteristics of the voltage divider or shunt.

CN102136858A discloses a base station correction method and a correction device. The method comprises the following steps of: storing phase and/or amplitude compensation data of each correction path in advance before phase and/or amplitude correction is performed on each transmission module and/or a receiving module by adopting corresponding correction paths respectively; and performing phase and/or amplitude compensation on each correction path according to the phase and/or amplitude compensation data. The device comprises a storage module and a compensation module, wherein the storage module stores the phase and/or amplitude compensation data of each correction path; and the compensation module is used for performing the phase and/or amplitude compensation on each correction path according to the phase and/or amplitude compensation data in the storage module before the phase and/or amplitude correction is performed on each transmission module and/or each receiving module by adopting the corresponding correction paths respectively. By the method and the device, the base station correction accuracy can be improved, and the process requirements of a correction network are reduced.

Therefore, existing phase calibration methods cannot fulfill the requirement of accuracy and efficiency of phase-frequency calibration of wide-range meters.

### Brief description of the invention

The invention is defined in the appended claims: independent claim 1 defines a zero calibration method, independent claim 6 defines the corresponding computer device, while independent claim 8 defines the corresponding storage medium. Further aspects are defined by the corresponding dependent claims.

### Description of the drawings

In order to illustrate the technical solutions in the embodiments of the present application more clearly, the drawings to be utilized in the embodiments will be briefly introduced below. Obviously, the drawings in the following description are only some embodiments of the present application. Those of ordinary skills in the art can also achieve other drawings based on these drawings without creative efforts.
Fig. 1 is a schematic drawing of connection of zero-phase calibration between a large-range channel and a small-range channel of a vector voltage analyzer by means of a voltage divider according to one or more embodiments in the prior art.
Fig. 2 is a schematic drawing of an application environment of a zero-phase calibration method according to one or more embodiments.
Fig. 3 is a schematic drawing of a calibration environment of the zero-phase calibration method according to one or more embodiments.
Fig. 4 is a flow chart of the zero-phase calibration method according to one or more embodiments.
Fig. 5 is a matrix diagram of phase calibration parameters between channel signals of each range combination when calibrating with the zero-phase calibration method according to one or more embodiments.

### Detailed description of the invention

In order to make the technical solutions and advantages of the present application more apparent, the present application will be further described in detail below with reference to the drawings and embodiments. It should be understood that the specific embodiments described herein are only used to illustrate the present application without limiting it.

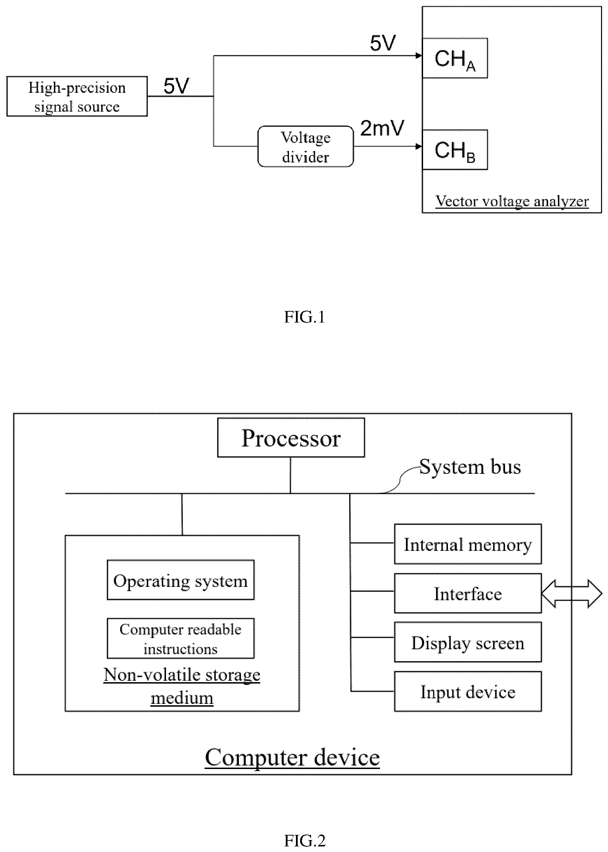

Referring to Fig. 1, which is a schematic drawing of connection of zero-phase calibration between a channel with a large range and a channel with a small range of a vector voltage analyzer by means of a voltage divider in the prior art. As shown in Fig. 1, when measuring with the vector voltage analyzer, there is a combination of a large range of 5V and a small range of 2mV between different channels CH_{A} and CH_{B}. The initial calibration utilizes a high-precision signal source to output two channels of signals with the full-scale amplitude of the large range of 5V, with one channel of signal being directly input into the channel CH_{A} with the large range of 5V of the vector voltage analyzer to be calibrated, while the other channel of signal being introduced into a voltage divider to obtain a signal with a small-amplitude of the small range of 2mV, so as to be input into the channel CH_{B} with the small range of 2mV of the vector voltage analyzer to be calibrated. Nevertheless, such a calibration method cannot achieve high-precision phase quantitative dissemination as the limitation of phase-frequency characteristics of the voltage divider. In addition, it is necessary to use a voltage divider to obtain a signal with the corresponding small amplitude and input it into the channel with a small range for initial calibration for other range combinations with a large span between channels of the vector voltage analyzer, which makes the calibration process very time-consuming.

The technical solutions in the embodiments of the present application will be clearly and completely described below with reference to the accompanying drawings of the embodiments thereof, so that the purpose and advantages of the present application will be more clearly understood. Obviously, the embodiments as described are part of the embodiments of the present application, but not exhaustive embodiments.

Referring to Fig. 2, which is a schematic drawing of the application environment of the zero-phase calibration method provided by an embodiment of the present application. In the application environment as shown in Fig. 2, the computer device can be a server, and its internal structure diagram can be as shown in Fig. 2. The computer device comprises a processor, a memory, an interface and a database connected through a system bus. Wherein, the processor of the computer device is used to provide computing and control capabilities. The memory of the computer device includes a non-volatile storage medium and an internal memory. The non-volatile storage medium stores an operating system, computer-readable instructions and the database. The internal memory provides an environment for execution of the computer-readable instructions and the operating system in the non-volatile storage medium. The database of the computer device is used for storing data of the zero-phase calibration method. The interface of the computer device is used for communication with external terminals. The computer readable instructions, when executed by the processor, can implement the zero-phase calibration method.

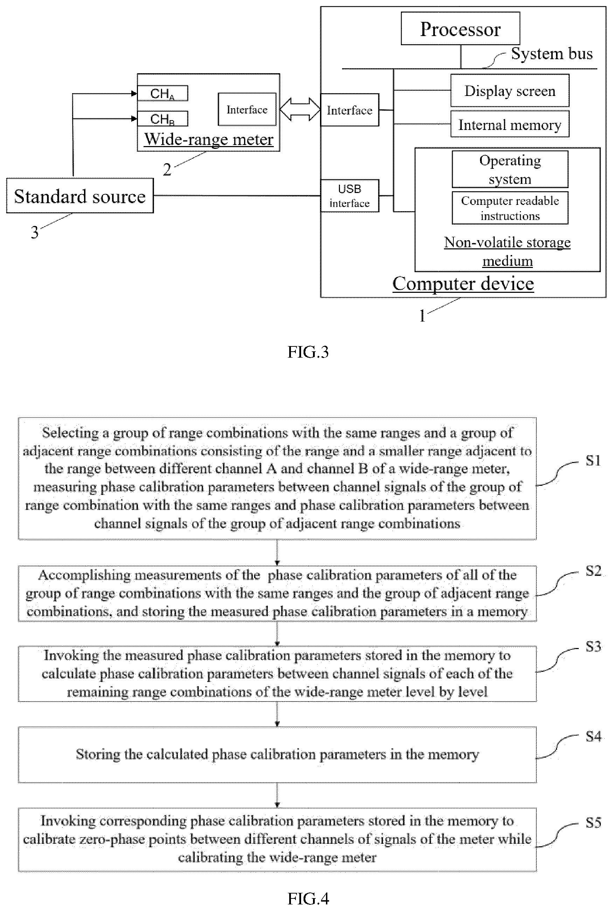

Referring to Fig. 3, which is a schematic drawing of the calibration environment of the zero-phase calibration method provided by an embodiment of the present application. In the calibration environment as shown in Fig. 3, automatic calibration of zero-phase points between different channels of the wide-range meter 2 is realized through the computer device 1. The computer device 1 is similar to the computer device as shown in Fig. 2 and will not be described repetitively herein.

In the embodiment as shown in Fig. 3, the zero-phase point between two different channels CH_{A} and CH_{B} of the wide-range meter 2 is automatically calibrated by means of the computer device 1 executing the zero-phase calibration method as claimed in the present application which controls a standard source 3. The wide-range meter 2 is a meter with extensive ranges and a plurality of signal channels, including but not limited to a vector voltage analyzer, a phase meter, a three-phase standard energy meter, etc. Such type of meter comprises more than two signal channels. Each channel has a plurality of measurement ranges, and the range amplitudes of corresponding measurement range of each channel are equal. For example, the range amplitude of the i-th range of the channel CH_{A} and the i-th range of the channel CH_{B} are equal. The standard source 3 is a high-precision signal source with high stability, low noise as well as with adjustable amplitude and frequency, such as a multifunctional calibrator with the model TD1880 developed by the applicant of the present application.

### Concept of the invention

The basic principle of the present application is that, for two different channels CH_{A} and CH_{B} of a wide-range meter 2, selecting the i1-th range and the i2-th range of the channel CH_{A}, and the j 1-th range and the j2-th range of the channel CH_{B}, the phase calibration parameters, namely, the phase differences between channel signals S_{A}, S_{B} of each range combination form a second-order matrix as shown in Table 1. The calculation formulas of the phase calibration parameters between the channel signals S_{A}, S_{B} of each range combination are illustrated in formula (I) to formula (IV) respectively.

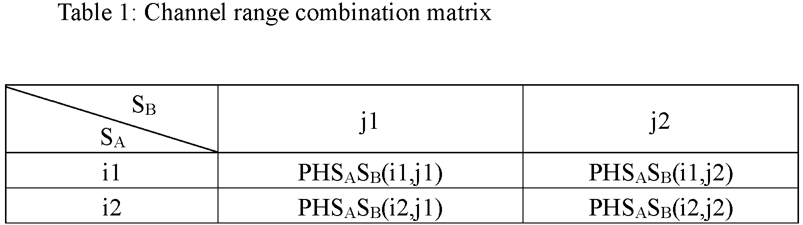

${PHS}_{A} {S}_{B} \left(i1,j1\right) = {PHS}_{B} \left[j1\right] - {PHS}_{A} \left[i1\right]$ (I) ${PHS}_{A} {S}_{B} \left(i1,j2\right) = {PHS}_{B} \left[j2\right] - {PHS}_{A} \left[i1\right]$ (II) ${PHS}_{A} {S}_{B} \left(i2,j1\right) = {PHS}_{B} \left[j1\right] - {PHS}_{A} \left[i2\right]$ (III) ${PHS}_{A} {S}_{B} \left(i2,j2\right) = {PHS}_{B} \left[j2\right] - {PHS}_{A} \left[i2\right]$ (IV)

According to the above formula (I) to formula (IV), the following equation (V) can be derived:
${PHS}_{A} {S}_{B} \left(i1,j1\right) + {PHS}_{A} {S}_{B} \left(i2,j2\right) = {PHS}_{A} {S}_{B} \left(i1,j2\right) + {PHS}_{A} {S}_{B} \left(i2,j1\right)$ (V)

Therefore, for any range combination in the form of a second-order matrix, providing that phase calibration parameters of three range combinations thereof are determined, the phase calibration parameter of the other range combination can be calculated through the above equation (V).

Furthermore, the inventor of the present application found that, when the effective value of a signal input reaches 10% of the range amplitude, its influence on phase measurement characteristics can be ignored. In particular, when the effective value of the signal input reaches 40% of the range amplitude, there is almost no influence on the phase measurement characteristics. Therefore, by selecting combinations of adjacent ranges, providing a smaller range reaches 10% of the full-scale amplitude of a larger range among the adjacent ranges, phase calibration parameters of three combinations in a second-order range combination matrix can be directly measured with the above characteristics, while the phase calibration parameter of the other range combination can be calculated through the above equation (V) taking advantage of the feature that the input channel signals are with zero phase difference. Phase calibration parameters of all range combinations can be derived through step-by-step calculation, and so forth. Thus the limitation of necessity to use a voltage divider or shunt when the range span is wide can be avoided.

Fig. 4 provides a flow chart of the zero-phase calibration method according to an embodiment of the present application. The method includes: step S1, selecting a group of range combinations with the range and a group of adj acent range combinations consisting of the range and a smaller range adjacent to the range between different channels A and B of a wide-range meter, measuring phase calibration parameters between channel signals of the group of range combinations with the same ranges and phase calibration parameters between channel signals of the group of adjacent range combinations; step S2, accomplishing measurements of phase calibration parameters of all of the group of range combinations with the same ranges and the group of adjacent range combinations, and storing the measured phase calibration parameters in a memory; step S3, invoking the measured phase calibration parameters stored in the memory to calculate phase calibration parameters between channel signals of each of the remaining range combinations of the wide-range meter level by level; step S4, storing the phase calibration parameters calculated in step S3 in the memory; and step S5, invoking corresponding phase calibration parameters stored in the memory to calibrate zero-phase points between different channels of signals of the meter while calibrating the wide-range meter.

According to preferable embodiments of the present application, the ratio between the smaller range and the larger range of adjacent range combinations of the wide-range meter reaches at least 0.1. As non-limiting examples, the ratio between the smaller range and the larger range of adjacent range combinations of the range meter can be 0.1, 0.2, 0.3, 0.4, 0.5, 0.6, 0.7, 0.8 or 0.9. Particularly preferably, the ratio between the smaller range and the larger range of adjacent range combinations of the wide-range meter is 0.4 or 0.5.

Continuing to refer to Fig. 4, in step S1, signals with the full-scale amplitude of the adj acent besides smaller range are output to channel A and channel B of the wide-range meter 2 by the standard source 3, and phase calibration parameters PHS_{A}S_{B}(1,1), PHS_{A}S_{B} (1,2),..., PHS_{A}S_{B} (i,i), PHS_{A}S_{B}(i,i+1),..., PHS_{A}S_{B} (n,n) between channel signals S_{A}, S_{B} of the group of range combinations with the same ranges as well as between channel signals S_{A}, S_{B} of the group of adjacent range combinations are measured, wherein n is the number of measurement ranges of the wide-range meter 2, i is an integer and 1≤i≤n-1; in step S2, measurements of phase calibration parameters of all of the group of range combinations with the same ranges and the group of adjacent range combinations are accomplished and the measured phase calibration parameters are stored in the memory; in step S3, the measured phase calibration parameters stored in the memory are invoked, according to the equation PHS_{A}S_{B}(i1,j1) + PHS_{A}S_{B}(i2,j2) = PHS_{A}S_{B}(i1,j2) + PHS_{A}S_{B}(i2,j1), PHS_{A}S_{B}(i+1,i) is calculated by use of the formula PHS_{A}S_{B}(i+1,i)= PHS_{A}S_{B}(i,i)+ PHS_{A}S_{B}(i+1,i+1)-PHS_{A}S_{B}(i,i+1), and PHS_{A}S_{B}(j+2,j) is calculated by use of the formula PHS_{A}S_{B}(j+2,j)= PHS_{A}S_{B}(j+1,j)+ PHS_{A}S_{B}(j+2,j+1)-PHS_{A}S_{B}(j+1,j+1), PHS_{A}S_{B}(j,j+2) is calculated by use of the formula PHS_{A}S_{B}(j,j+2)= PHS_{A}S_{B}(j,j+1)+ PHS_{A}S_{B}(j+1,j+2)- PHS_{A}S_{B}(j+1,j+1), wherein j is an integer and 1≤j≤n-2, and so forth, phase calibration parameters between the channel signals S_{A}, S_{B} of each of the remaining range combinations of the wide-range meter are calculated level by level.

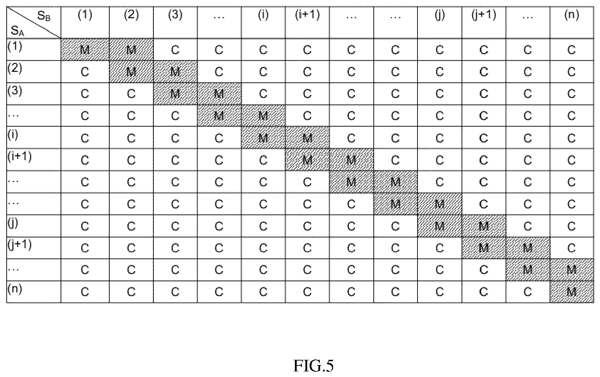

Referring to Fig. 5, which is a matrix diagram of phase calibration parameters between channel signals of each range combination when calibrating with the zero-phase calibration method provided by an embodiment of the present application. Wherein, n is the number of measurement ranges of the wide-range meter 2, n is an integer and n≥3, i and j represent the i-th measurement range and the j-th measurement range of channel CH_{A} or channel CH_{B} of the wide-range meter 2 respectively, both i and j are integers and 1≤i<j≤n-1. The range combinations in the matrix diagram consist of a certain measurement range of the channel CH_{A} and a certain measurement range of the channel CH_{B}. In each range combination of the channels CH_{A} and CH_{B}, the phase calibration parameters between the channel signals S_{A}, S_{B} of the range combination indicated by the letter M in the matrix diagram are the parameters directly measured by use of the standard source in the above step S1. The phase calibration parameters between the channel signals S_{A}, S_{B} of the range combination indicated by the letter C in the matrix diagram are the parameters calculated level by level according to the equation PHS_{A}S_{B}(i1,j1) + PHS_{A}S_{B}(i2,j2)= PHS_{A}S_{B}(i1,j2) + PHS_{A}S_{B}(i2,j1) in the above step S3.

Referring to Fig. 3 to Fig. 5 simultaneously, in the calibration environment of the zero-phase calibration method as shown in Fig. 3, when the zero-phase point between different channels CH_{A} and CH_{B} of the wide-range meter 2 is to be calibrated by use of the zero-phase calibration method as in the present application through a computer device 1, a group of range combinations with the same ranges as well as a group of adjacent range combinations consisting of the range and a smaller range adjacent to the range are selected between two different channels CH_{A}, CH_{B} of the wide-range meter 2 at first. With the computer device 1 controlling the standard source 3, signals with the full-scale amplitude of the adjacent besides smaller range are output, and two channels of signals are synchronously input into channels CH_{A} and CH_{B} of the wide-range meter 2, thereby the phase calibration parameters between channel signals S_{A}, S_{B} of the group of range combinations with the same ranges and between channel signals S_{A}, S_{B} of the group of adjacent range combinations are measured, which are indicated by the letter M in the matrix diagram of Fig. 5. The measured phase calibration parameters are transmitted to the memory of the computer device 1 for storage through the interface of the wide-range meter 2. Then, measurements of phase calibration parameters of all of the group of range combinations with the same ranges and the group of adjacent range combinations are accomplished, and the measured phase calibration parameters are stored in the memory, the processor of the computer device 1 invokes the measured phase calibration parameters stored in the memory to calculate the phase calibration parameters (which are indicated by the letter C in the matrix diagram of Fig. 5) between the channel signals S_{A}, S_{B} of each of the remaining range combinations of the wide-range meter level by level according to the above equation (V), and they are stored in the memory of the computer device 1. Finally, the corresponding phase calibration parameters stored in the memory are invoked by the computer device 1 to automatically calibrate the zero-phase point between channels CH_{A} and CH_{B} of the wide-range meter 2. It should be noted, the computer device 1 is able to communicate with the standard source 3 through a USB interface so as to control the output signal of the standard source 3. The communication mode between the standard source 3 and the computer device 1 includes GPIB mode and RS232 mode, without limitation.

The wide-range meter 2 in the specification has a plurality of channels, each channel has more than two measurement ranges, and the range amplitudes of corresponding measurement ranges of each channel are equal. The measurement signals of channels of such wide-range, multi-channel meters can be AC voltage signals or AC current signals. Non-limiting examples of the wide-range meter comprise a multi-channel vector voltage analyzer with a voltage range in the range of 2mV-5V; a multi-channel phase meter with a voltage range in the range of 10mV-630V; a three-phase standard energy meter with a voltage range in the range of 60V-720V; a power analyzer with a voltage range in the range of 50mV-1000V and a current range in the range of 5mA-30A.

According to preferable embodiments of the present application, the wide-range meter 2 is a multi-channel vector voltage analyzer with the number of measurement ranges n of 11, wherein the measurement ranges of two measurement channels of voltage are set to [5V, 2V, 1V, 500mV, 200mV, 100mV, 50mV, 20mV, 10mV, 5mV, 2mV]. In the following, a phase calibration experiment was performed on the vector voltage analyzer according to the method described in the present application to verify the effectiveness of the method of the application.

### Experimental data

The experiment was directed to a typical calibration environment of a vector voltage analyzer with the model TH2000 being developed by the applicant of this application, three types of signal frequency of the standard source 3 were selected as the frequency of input voltage signals of the vector voltage analyzer, namely power frequency of 53Hz, intermediate frequency of 1kHz and high frequency of 10kHz. The experiment selected calibration parameters measured and calculated at the intermediate frequency of 1kHz as a criterion. Firstly, phase calibration parameters between channel signals of the group of range combinations with the same ranges and phase calibration parameters between channel signals of the group of adjacent range combinations were measured. After measurements of phase calibration parameters of all of the group of range combinations with the same ranges and the group of adjacent range combinations were accomplished and the measured phase calibration parameters were stored in a memory, the measured phase calibration parameters stored in the memory were invoked to calculate each of the remaining range combinations of the wide-range meter level by level and they were stored in the memory. Then, the corresponding phase calibration parameters stored in the memory were invoked to automatically calibrate the zero-phase point between the channels of the vector voltage analyzer.

Table 2 below is a table of phase calibration parameters measured and calculated at the intermediate frequency of 1kHz (unit: nanosecond [ns], RG1 represents the selected range of channel CH_{A} of signal S_{A}, RG2 represents the selected range of channel CH_{B} of signal S_{B}).

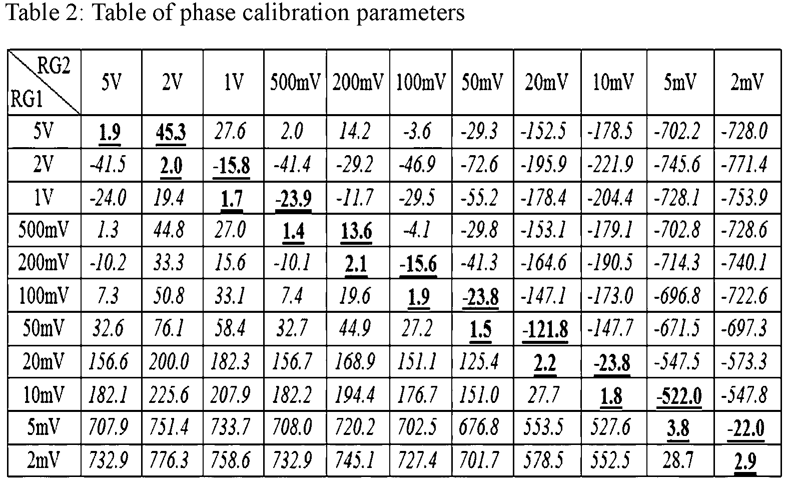

It should be noted, the underlined values in the above Table 2 pertain to directly measured phase calibration parameters (wherein the ratio between the smaller range and the larger range of adjacent range combinations is 0.4 or 0.5), and other values pertain to the phase calibration parameters calculated by the method according to the present application.

The experiment ran measurements as well on the actual phase differences before calibration for the range combinations with the ratio between the smaller range and the larger range reached 0.1 whilst the range combinations included the ranges of 100mV and above. The actual phase differences were compared to the corresponding data listed in the above Table 2 and then converted into angle values to evaluate the influence of measurement error. The results show that at the power frequency of 53Hz, the phase error is within 2µrad; at the intermediate frequency of 1kHz, the phase error is within 1µrad; at the high frequency of 10kHz, the phase error is within 10µrad. It is well known to those skilled in the art that the above values of error are within a negligible range at the corresponding frequency. Thus, it can be verified that as discussed above in this application, when the effective value of an input signal reaches 10% of the range amplitude, the influence on the phase measurement characteristics can be ignored.

In the following, data that meet the requirement of phase difference measured after the vector voltage analyzer being overwritten by the phase calibration parameters are selected to evaluate the effectiveness of the zero-phase calibration method of the present application.

Particularly, Table 3 below shows phase differences measured after the vector voltage analyzer being overwritten by the phase calibration parameters listed in Table 2 while the input signals are at the power frequency of 53Hz (unit: µrad, RG1 represents the selected range of channel CH_{A} of signal S_{A}, RG2 represents the selected range of channel CH_{B} of signal S_{B}). It should be noted, the range combinations without slash in Table 3 meet the requirement that the ratio between the smaller range and the larger range reaches 0.1, the values of measured phase differences listed in such range combination boxes are substantially accurate and can be used to evaluate the state of phase calibration. The range combinations marked with slash in Table 3 do not meet the requirement that the ratio between the smaller range and the larger range reaches 0.1, and the values of measured phase differences may include considerable errors, they are listed in the table for reference.

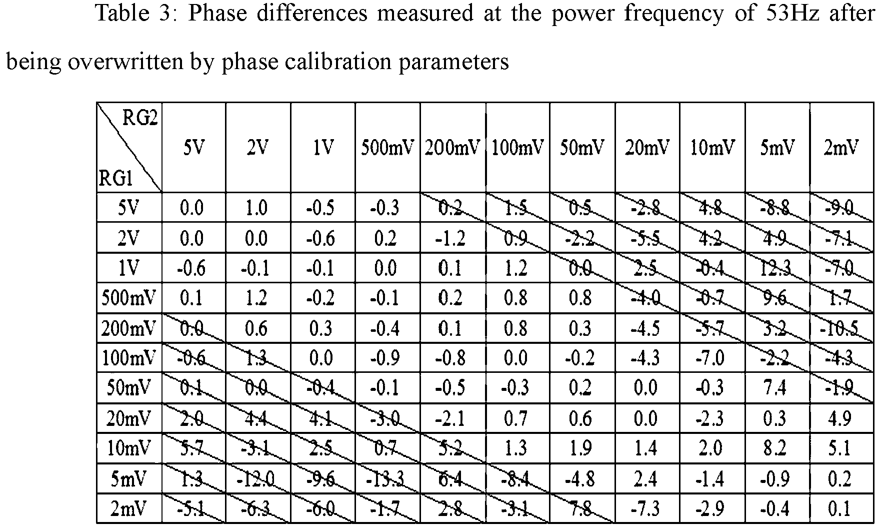

It can be seen from the data in Table 3, the absolute values of phase differences measured at the power frequency of 53Hz after the vector voltage analyzer being overwritten by the phase calibration parameters listed in Table 2 obtained according to the method of the present application are all considerably small. Among the range combinations without slash, the absolute values of phase differences of the range combinations that only include the range of 100mV and above are all within 2µrad, and the absolute values of phase differences of the range combinations that only include the range of 100mV and below are all within 10µrad. It is well known to those skilled in the art that such values of phase differences are within a substantially negligible range at the corresponding frequency and measurement range. Therefore, it can be determined that the vector voltage analyzer after calibration has returned to zero with regard to phase difference.

Table 4 below shows phase differences measured after the vector voltage analyzer being overwritten by the phase calibration parameters listed in Table 2 while the input signals are at an intermediate frequency of 1kHz (unit: µrad, RG1 represents the selected range of channel CH_{A} of signal S_{A}, RG2 represents the selected range of channel CH_{B} of signal S_{B}). Similarly, the range combinations without slash in Table 4 meet the requirement that the ratio between the smaller range and the larger range reaches 0.1, and can be used to evaluate the state of phase calibration. It can be seen from the data in Table 4 that, the absolute values of phase differences measured at the intermediate frequency of 1kHz after the vector voltage analyzer being overwritten by the phase calibration parameters listed in Table 2 obtained according to the method of the present application are all considerably small. Among the range combinations without slash, the absolute values of phase differences of the range combinations that only include the range of 100mV and above are all within 1µrad, and the absolute values of phase differences of the range combinations that only include the range of 100mV and below are all within 10µrad. It is well known to those skilled in the art that such values of phase differences are within a substantially negligible range at the corresponding frequency and measurement range. Therefore, it can be determined that the vector voltage analyzer after calibration has returned to zero with regard to phase difference.

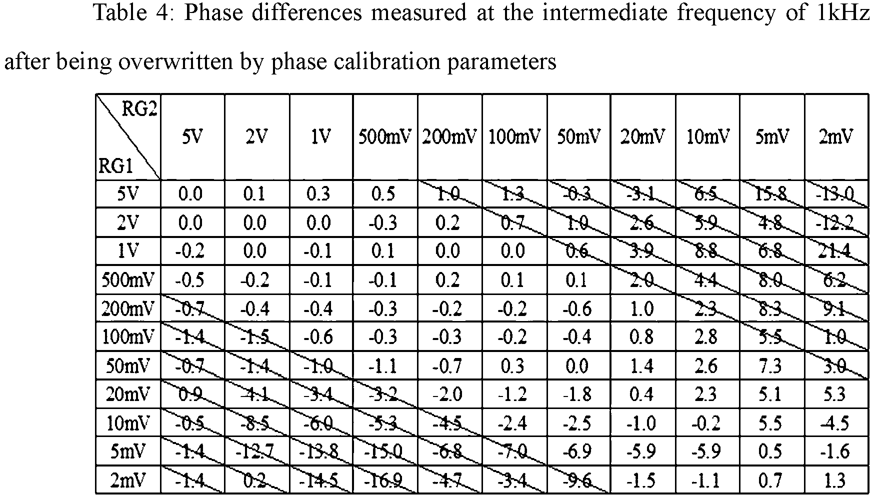

Table 5 below shows phase differences measured after the vector voltage analyzer being overwritten by the phase calibration parameters listed in Table 2 while the input signals are at the high frequency of 10kHz (unit: µrad, RG1 represents the selected range of channel CH_{A} of signal S_{A}, RG2 represents the selected range of channel CH_{B} of signal S_{B}).

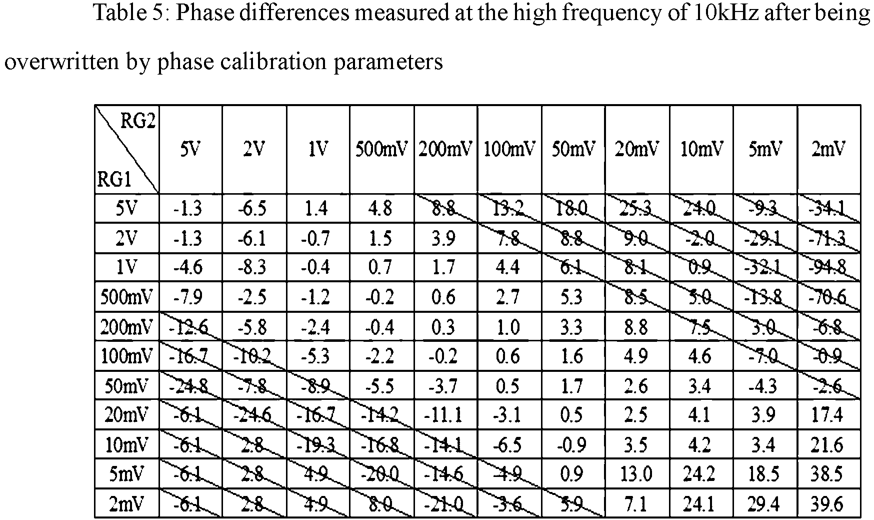

Similarly, the range combinations without slash in Table 5 meet the requirement that the ratio between the smaller range and the larger range reaches 0.1, and can be used to evaluate the state of phase calibration. It can be seen from the data in Table 5, the absolute values of phase differences measured at the high frequency of 10kHz after the vector voltage analyzer being overwritten by the phase calibration parameters listed in Table 2 obtained according to the method of the present application are all considerably small. Among the range combinations without slash, the absolute values of phase differences of the range combinations that only include the range of 100mV and above are all within 10µrad, and the absolute values of phase differences of the range combinations that only include the range of 100mV and below are all within 50µrad. It is well known to those skilled in the art that such values of phase difference are within a substantially negligible range at the corresponding frequency and measurement range. Therefore, it can be determined that the vector voltage analyzer after calibration has returned to zero with regard to phase difference.

Therefore, it can be known from the above experiment that the zero-phase calibration method of the present application can be utilized to effectively calibrate the zero-phase point between signals of different channels of wide-range meters at various frequencies.

It should be noted that the above embodiments are only used to illustrate the technical solutions of the present application without limitation. The above embodiments or the technical features in different embodiments can be further combined without departing from the scope of the invention, as defined in the appended claims.

It should be understood, although various steps in the flow chart of Fig. 4 are shown in sequence as indicated by arrows, these steps are not necessarily implemented in the order indicated by arrows. Unless explicitly stated in the context, there is no strict order restriction on the implementation of these steps, and these steps can be executed in other orders within the scope of the invention, as defined in the appended claims.

A computer device comprises a memory and one or more processors. Computer-readable instructions are stored in the memory. When the computer-readable instructions are executed by the processors, one or more processors are made to implement the following steps:
step S1, selecting a group of range combinations with the same ranges and a group of adjacent range combinations consisting of the range and a smaller range adjacent to the range between different channels A and B of the wide-range meter, measuring phase calibration parameters between channel signals of the group of range combinations with the same ranges and phase calibration parameters between channel signals of the group of adjacent range combinations;
step S2, accomplishing measurements of phase calibration parameters of all of the group of range combinations with the same ranges and the group of adjacent range combinations, and storing the measured phase calibration parameters in a memory;
step S3, invoking the measured phase calibration parameters stored in the memory to calculate phase calibration parameters between channel signals of each of the remaining range combinations of the wide-range meter level by level;
step S4, storing the calculated phase calibration parameters in the memory; and
step S5, invoking corresponding phase calibration parameters stored in the memory to calibrate the zero-phase points between different channels of signals of the meter while calibrating the wide-range meter.

In some embodiments, the ratio between the smaller range and the larger range of the adjacent range combinations of the wide-range meter reaches at least 0.1.

In some embodiments, in the step S1, signals with the full-scale amplitude of the adjacent besides smaller range are output to the channels A and B of the wide-range meter by a standard source, phase calibration parameters PHS_{A}S_{B}(1,1), PHS_{A}S_{B} (1,2),..., PHS_{A}S_{B} (i,i), PHS_{A}S_{B}(i,i+1),..., PHS_{A}S_{B} (n,n) between channel signals S_{A}, S_{B} of the group of range combinations with the same ranges as well as between channel signals S_{A}, S_{B} of the group of adjacent range combinations are measured, wherein n is the number of measurement ranges of the wide-range meter, i is an integer and 1≤i≤n-1.

In some embodiments, in the step S3, the measured phase calibration parameters stored in the memory are invoked, according to the equation PHS_{A}S_{B}(i1,j1) + PHS_{A}S_{B}(i2,j2) = PHS_{A}S_{B}(i1,j2) + PHS_{A}S_{B}(i2,j1), PHS_{A}S_{B}(i+1,i) is calculated by use of the formula PHS_{A}S_{B}(i+1,i)= PHS_{A}S_{B}(i,i)+ PHS_{A}S_{B}(i+1,i+1)-PHS_{A}S_{B}(i,i+1), and PHS_{A}S_{B}(j+2,j) is calculated by use of the formula PHS_{A}S_{B}(j+2,j)= PHS_{A}S_{B}(j+1,j)+ PHS_{A}S_{B}(j+2,j+1)- PHS_{A}S_{B}(j+1,j+1), PHS_{A}S_{B}(j,j+2) is calculated by use of the formula PHS_{A}S_{B}(j,j+2)= PHS_{A}S_{B}(j,j+1)+ PHS_{A}S_{B}(j+1,j+2)- PHS_{A}S_{B}(j+1,j+1), wherein j is an integer and 1≤j≤n-2, and so forth, phase calibration parameters between the channel signals S_{A}, S_{B} of each of the remaining range combinations of the wide-range meter are calculated level by level.

In some embodiments, the ratio between the smaller range and the larger range of the adjacent range combination of the wide-range meter is 0.4 or 0.5.

In some embodiments, the channel signals are AC voltage signals.

A non-volatile computer-readable storage medium stores computer-readable instructions. When the computer-readable instructions are executed by processors, one or more processors are made to implement the following steps:
step S1, selecting a group of range combinations with the same ranges and a group of adjacent range combinations consisting of the range and a smaller range adjacent to the range between different channels A and B of the wide-range meter, measuring phase calibration parameters between channel signals of the group of range combinations with the same ranges and phase calibration parameters between channel signals of the group of adjacent range combinations;
step S2, accomplishing measurements of phase calibration parameters of all of the group of range combinations with the same ranges and the group of adjacent range combinations, and storing the measured phase calibration parameters in a memory;
step S3, invoking the measured phase calibration parameters stored in the memory to calculate phase calibration parameters between channel signals of each of the remaining range combinations of the wide-range meter level by level;
step S4, storing the calculated phase calibration parameters in the memory; and
step S5, invoking corresponding phase calibration parameters stored in the memory to calibrate the zero-phase points between different channels of signals of the meter while calibrating the wide-range meter.

In some embodiments, the ratio between the smaller range and the larger range of the adjacent range combinations of the wide-range meter reaches at least 0.1.

In some embodiments, in the step S1, signals with the full-scale amplitude of the adjacent besides smaller range are output to the channels A and B of the wide-range meter by a standard source, phase calibration parameters PHS_{A}S_{B}(1,1), PHS_{A}S_{B} (1,2),..., PHS_{A}S_{B} (i,i), PHS_{A}S_{B}(i,i+1),..., PHS_{A}S_{B} (n,n) between channel signals S_{A}, S_{B} of the group of range combinations with the same ranges as well as between channel signals S_{A}, S_{B} of the group of adjacent range combinations are measured, wherein n is the number of measurement ranges of the wide-range meter, i is an integer and 1≤i≤n-1.

In some embodiments, in the step S3, the measured phase calibration parameters stored in the memory are invoked, according to the equation PHS_{A}S_{B}(i1,j1) + PHS_{A}S_{B}(i2,j2) = PHS_{A}S_{B}(i1,j2) + PHS_{A}S_{B}(i2,j1), PHS_{A}S_{B}(i+1,i) is calculated by use of the formula PHS_{A}S_{B}(i+1,i)= PHS_{A}S_{B}(i,i)+ PHS_{A}S_{B}(i+1,i+1)-PHS_{A}S_{B}(i,i+1), and PHS_{A}S_{B}(j+2,j) is calculated by use of the formula PHS_{A}S_{B}(j+2,j)= PHS_{A}S_{B}(j+1,j)+ PHS_{A}S_{B}(j+2,j+1)- PHS_{A}S_{B}(j+1,j+1), PHS_{A}S_{B}(j,j+2) is calculated by use of the formula PHS_{A}S_{B}(j,j+2)= PHS_{A}S_{B}(j,j+1)+ PHS_{A}S_{B}(j+1,j+2)- PHS_{A}S_{B}(j+1,j+1), wherein j is an integer and 1≤j≤n-2, and so forth, phase calibration parameters between the channel signals S_{A}, S_{B} of each of the remaining range combinations of the wide-range meter are calculated level by level.

In some embodiments, the ratio between the smaller range and the larger range of the adjacent range combination of the wide-range meter is 0.4 or 0.5.

In some embodiments, the channel signals are AC voltage signals.

It can be understood by those of ordinary skills in the art that all or part of the processes in realizing the method of the above embodiments can be fulfilled by instructing relevant hardware through computer-readable instructions. The computer-readable instructions can be stored in a non-volatile computer-readable device. The computer-readable instructions may include the processes of the embodiments of the above method when executed. Wherein, any reference to a memory, storage, database or other medium used in various embodiments provided in the present application may include non-volatile and/or volatile memory. Non-volatile memory may include read-only memory (ROM), programmable ROM (PROM), electrically programmable ROM (EPROM), electrically erasable programmable ROM (EEPROM), or flash memory. Volatile memory may include random access memory (RAM) or external cache memory. By way of illustration rather than limitation, RAM is available in many forms, such as static RAM (SRAM), dynamic RAM (DRAM), synchronous DRAM (SDRAM), double data rate SDRAM (DDRSDRAM), enhanced SDRAM (ESDRAM), Synchlink DRAM (SLDRAM), Rambus direct RAM (RDRAM), direct memory bus dynamic RAM (DRDRAM), and memory bus dynamic RAM (RDRAM), etc.

The above embodiments only illustrate several embodiments of the present application, and their descriptions are relatively specific and in detail, but they should not be construed as limiting the scope of the invention. It should be noted, for those of ordinary skills in the art, that various modifications and variations can be made within the scope of the invention, as defined in the appended claims.

## Claims

1. A zero-phase calibration method for calibrating zero-phase points between different channels of signals of a wide-range meter (2), wherein the wide-range meter (2) comprises a plurality of measurement ranges denoted as *R*₁, *R*₂, . . . , *Rₙ*, wherein n is the total number of measurement ranges, and the measurement ranges are ordered such that *Rᵢ* represents a larger measurement range than R_{*i*+1}, for i=1... n-1;
wherein the method includes:
step S1, selecting a group of range combinations (*Rᵢ, Rᵢ*) consisting of a measurement range *Rᵢ* of a channel A and the same measurement range *Rᵢ* of another channel B, a group of range combinations (*R*_{*i*+1}, *R*_{*i*+1}) consisting of a measurement range *R*_{*i*+1} of the channel A and the same measurement range *R*_{*i*+1} of the channel B and a group of adjacent range combinations (*Rᵢ, R*_{*i*+1}) consisting of the measurement range *Rᵢ* of the channel A and a smaller measurement range *R*_{*i*+1} adjacent to the measurement range *Rᵢ* of the channel B, for each i = 1..n-1, outputting signals with the full-scale amplitude of the smaller measurement range of the wide-range meter (2) by a standard source (3), measuring a phase calibration parameter PHS_{A}S_{B}(i,i) between channel signals S_{A} and S_{B} for the range combination (*Rᵢ, Rᵢ*), a phase calibration parameter PHS_{A}S_{B}(i+1,i+1) between channel signals S_{A} and S_{B} for the range combination (*R*_{*i*+1}, *R*_{*i*+1}) and a phase calibration parameter PHS_{A}S_{B}(i,i+1) between channel signals S_{A} and S_{B} for the adjacent range combination (*Rᵢ, R*_{*i*+1});;
step S2, storing the phase calibration parameters in a memory;
**characterized in that** the method further includes:
step S3, invoking the measured phase calibration parameters stored in the memory, according to the equation PHS_{A}S_{B}(i1,j1) + PHS_{A}S_{B}(i2,j2) = PHS_{A}S_{B}(i1,j2) + PHS_{A}S_{B}(i2,j1), calculating PHS_{A}S_{B}(i+1,i) by use of the formula PHS_{A}S_{B}(i+1,i)= PHS_{A}S_{B}(i,i)+ PHS_{A}S_{B}(i+1,i+1)-PHS_{A}S_{B}(i,i+1), and calculating PHS_{A}S_{B}(j+2,j) by use of the formula PHS_{A}S_{B}(j+2,j)= PHS_{A}S_{B}(j+1,j)+ PHS_{A}S_{B}(j+2,j+1)- PHS_{A}S_{B}(j+1,j+1), calculating PHS_{A}S_{B}(j,j+2) by use of the formula PHS_{A}S_{B}(j,j+2)= PHS_{A}S_{B}(j,j+1)+ PHS_{A}S_{BG}+1,j+2)- PHS_{A}S_{B}(j+1,j+1), wherein j is an integer and 1≤j≤n-2, calculating phase calibration parameters between the channel signals S_{A}, S_{B} of each of the remaining range combinations of the wide-range meter (2) level by level;
step S4, storing the calculated phase calibration parameters in the memory; and
step S5, invoking corresponding phase calibration parameters stored in the memory to calibrate the zero-phase points between different channels of signals of the meter while calibrating the wide-range meter.

2. The method according to claim 1, **characterized in that**
the ratio between the smaller measurement range *R*_{*i*+1} and the larger measurement range *Rᵢ* of the adjacent range combinations (*Rᵢ, R*_{*i*+1}) of the wide-range meter (2) is greater than or equal to 0.1 and less than 1.

3. The method according to claim 2, **characterized in that**,
the ratio between the smaller measurement range *R*_{*i*+1} and the larger measurement range *Rᵢ* of the adjacent range combination (*Rᵢ, R*_{*i*+1}) of the wide-range meter (2) is 0.4 or 0.5.

4. The method according to claim 3, **characterized in that**, the channel signals are AC voltage signals.

5. The method according to claim 3, **characterized in that**, the channel signals are AC current signals.

6. A computer device comprising a memory and one or more processors, wherein computer-readable instructions are stored in the memory, when the computer-readable instructions are executed by said one or more processors, said one or more processors are made to implement the following steps:
step S1, selecting a group of range combinations (*Rᵢ, Rᵢ*) consisting of a measurement range *Rᵢ* of a channel A and the same measurement range *Rᵢ* of another channel B, a group of range combinations (*R*_{*i*+1}, *R*_{*i*+1}) consisting of a measurement range *R*_{*i*+1} of the channel A and the same measurement range *R*_{*i*+1} of the channel B and a group of adjacent range combinations (*Rᵢ, R*_{*i*+1}) consisting of the measurement range *Rᵢ* of the channel A and a smaller measurement range *R*_{*i*+1} adjacent to the measurement range *Rᵢ* of the channel B, for each i = 1..n-1, outputting signals with the full-scale amplitude of the smaller measurement range of a wide-range meter (2) by a standard source (3), measuring a phase calibration parameter PHS_{A}S_{B}(i,i) between channel signals S_{A} and S_{B} for the range combination (*Rᵢ, Rᵢ*), a phase calibration parameter PHS_{A}S_{B}(i+1,i+1) between channel signals S_{A} and S_{B} for the range combination (*R*_{*i*+1}, *R*_{*i*+1}) and a phase calibration parameter PHS_{A}S_{B}(i,i+1) between channel signals S_{A} and S_{B} for the adjacent range combination (*Rᵢ, R*_{*i*+1});
wherein the wide-range meter (2) comprises a plurality of measurement ranges denoted as *R*₁, *R*₂, . . . , *Rₙ*, wherein n is the total number of measurement ranges, and the measurement ranges are ordered such that *Rᵢ* represents a larger measurement range than R_{*i*+1}, for i=1... n-1;
step S2, storing the phase calibration parameters in a memory;
**characterized in that** the one or more processors are further made to implement the following steps:
step S3, invoking the measured phase calibration parameters stored in the memory, according to the equation PHS_{A}S_{B}(i1,j1) + PHS_{A}S_{B}(i2,j2) = PHS_{A}S_{B}(i1,j2) + PHS_{A}S_{B}(i2,j1), calculating PHS_{A}S_{B}(i+1,i) by use of the formula PHS_{A}S_{B}(i+1,i)= PHS_{A}S_{B}(i,i)+ PHS_{A}S_{B}(i+1,i+1)-PHS_{A}S_{B}(i,i+1), and calculating PHS_{A}S_{B}(j+2,j) by use of the formula PHS_{A}S_{B}(j+2,j)= PHS_{A}S_{B}(j+1,j)+ PHS_{A}S_{B}(j+2,j+1)- PHS_{A}S_{B}(j+1,j+1), calculating PHS_{A}S_{B}(j,j+2) by use of the formula PHS_{A}S_{B}(j,j+2)= PHS_{A}S_{B}(j,j+1)+ PHS_{A}S₃(j+1,j+2)- PHS_{A}S_{B}(j+1,j+1), wherein j is an integer and 1≤j≤n-2, calculating phase calibration parameters between the channel signals S_{A}, S_{B} of each of the remaining range combinations of the wide-range meter (2) level by level;
step S4, storing the calculated phase calibration parameters in the memory; and
step S5, invoking corresponding phase calibration parameters stored in the memory to calibrate the zero-phase points between different channels of signals of the meter while calibrating the wide-range meter (2).

7. The computer device according to claim 6, **characterized in that**,
the ratio between the smaller measurement range *R*_{*i*+1} and the larger measurement range *Rᵢ* of the adjacent range combinations (*Rᵢ, R*_{*i*+1}) of the wide-range meter (2) is greater than or equal to 0.1 and less than 1.

8. One or more non-transitory computer-readable storage medium storing computer-readable instructions, wherein when the computer-readable instructions are executed by one or more processors, said one or more processors are made to implement the following steps:
step S1, selecting a group of range combinations (*Rᵢ, Rᵢ*) consisting of a measurement range *Rᵢ* of a channel A and the same measurement range *Rᵢ* of another channel B, a group of range combinations (*R*_{*i*+1}, *R*_{*i*+1}) consisting of a measurement range *R*_{*i*+1} of the channel A and the same measurement range *R*_{*i*+1} of the channel B and a group of adjacent range combinations (*Rᵢ, R*_{*i*+1}) consisting of the measurement range *Rᵢ* of the channel A and a smaller measurement range *R*_{*i*+1} adjacent to the measurement range *Rᵢ* of the channel B, for each i = 1..n-1, outputting signals with the full-scale amplitude of the smaller measurement range of a wide-range meter (2) by a standard source (3), measuring a phase calibration parameter PHS_{A}S_{B}(i,i) between channel signals S_{A} and S_{B} for the range combination (*Rᵢ, Rᵢ*), a phase calibration parameter PHS_{A}S_{B}(i+1,i+1) between channel signals S_{A} and S_{B} for the range combination (*R*_{*i*+1}, *R*_{*i*+1}) and a phase calibration parameter PHS_{A}S_{B}(i,i+1) between channel signals S_{A} and S_{B} for the adjacent range combination (*Rᵢ, R*_{*i*+1});
wherein the wide-range meter (2) comprises a plurality of measurement ranges denoted as *R*₁, *R*₂, . . . , *Rₙ*, wherein n is the total number of measurement ranges, and the measurement ranges are ordered such that *Rᵢ* represents a larger measurement range than R_{*i*+1}, for i=1... n-1;
step S2, storing the phase calibration parameters in a memory;
**characterized in that** the one or more processors are further made to implement the following steps:
step S3, invoking the measured phase calibration parameters stored in the memory, according to the equation PHS_{A}S_{B}(i1,j1) + PHS_{A}S_{B}(i2,j2) = PHS_{A}S_{B}(i1,j2) + PHS_{A}S_{B}(i2,j1), calculating PHS_{A}S_{B}(i+1,i) by use of the formula PHS_{A}S_{B}(i+1,i)= PHS_{A}S_{B}(i,i)+ PHS_{A}S_{B}(i+1,i+1)-PHS_{A}S_{B}(i,i+1), and calculating PHS_{A}S_{B}(j+2,j) by use of the formula PHS_{A}S_{B}(j+2,j)= PHS_{A}S_{B}(j+1,j)+ PHS_{A}S_{B}(j+2,j+1)- PHS_{A}S_{B}(j+1,j+1), calculating PHS_{A}S_{B}(j,j+2) by use of the formula PHS_{A}S_{B}(j,j+2)= PHS_{A}S_{B}(j,j+1)+ PHS_{A}S₃(j+1,j+2)- PHS_{A}S_{B}(j+1,j+1), wherein j is an integer and 1≤j≤n-2, calculating phase calibration parameters between the channel signals S_{A}, S_{B} of each of the remaining range combinations of the wide-range meter (2) level by level;
step S4, storing the calculated phase calibration parameters in the memory; and
step S5, invoking corresponding phase calibration parameters stored in the memory to calibrate the zero-phase points between different channels of signals of the meter while calibrating the wide-range meter (2).

9. The storage medium according to claim 8, **characterized in that**,
the ratio between the smaller measurement range *R*_{*i*+1} and the larger measurement range *Rᵢ* of the adjacent range combinations (*Rᵢ, R*_{*i*+1}) of the wide-range meter (2) is greater than or equal to 0.1 and less than 1.

## Patentansprüche

1. Nullphasen-Kalibrierverfahren zum Kalibrieren von Nullphasenpunkten zwischen verschiedenen Signalkanälen eines Weitbereichsmessgeräts (2), wobei das Weitbereichsmessgerät (2) eine Vielzahl von Messbereichen umfasst, die als *R*₁, *R*₂*,*..., *Rₙ* bezeichnet sind, wobei n die Gesamtzahl der Messbereiche ist, und die Messbereiche so angeordnet sind, dass *Rᵢ* einen größeren Messbereich als *Rᵢ₊₁* darstellt, für i=1...n-1;
wobei das Verfahren einschließt:
Schritt S1, Auswählen einer Gruppe von Bereichskombinationen (*Rᵢ, Rᵢ*), bestehend aus einem Messbereich *Rᵢ* eines Kanals A und demselben Messbereich *Rᵢ* eines anderen Kanals B, einer Gruppe von Bereichskombinationen (*R*_{*i*+1}, *Rᵢ₊₁*), bestehend aus einem Messbereich *Rᵢ₊₁* des Kanals A und demselben Messbereich *Rᵢ₊₁* des Kanals B, und einer Gruppe benachbarter Bereichskombinationen (*Rᵢ, Rᵢ₊₁*), bestehend aus dem Messbereich *Rᵢ* des Kanals A und einem kleineren Messbereich *Rᵢ₊₁* benachbart zu dem Messbereich *Rᵢ* des Kanals B, für jedes i = 1..n-1, Ausgeben von Signalen mit der vollen Amplitude des kleineren Messbereichs des Weitbereichsmessgeräts (2) durch eine Standardquelle (3), Messen eines Phasenkalibrierungsparameters PHS_{A}S_{B} (i,i) zwischen den Kanalsignalen S_{A} und S_{B} für die Bereichskombination (*Rᵢ, Rᵢ*), eines Phasenkalibrierungsparameters PHS_{A}S_{B} (i+1,i+1) zwischen den Kanalsignalen S_{A} und S_{B} für die Bereichskombination (*R*_{*i*+1}, *Rᵢ₊₁*) und eines Phasenkalibrierungsparameters PHS_{A}S_{B} (i,i+1) zwischen den Kanalsignalen S_{A} und S_{B} für die benachbarte Bereichskombination (*Rᵢ, Rᵢ₊₁*);
Schritt S2, Speichern der Phasenkalibrierungsparameter in einem Speicher;
**dadurch gekennzeichnet, dass** das Verfahren ferner einschließt:
Schritt S3, Aufrufen der in dem Speicher gespeicherten gemessenen Phasenkalibrierungsparameter gemäß der Gleichung PHS_{A}S_{B}(i1,j1) + PHS_{A}S_{B}(i2,j2) = PHS_{A}S_{B}(i1,j2) + PHS_{A}S_{B}(i2,j1), Berechnen von PHS_{A}S_{B}(i+1,i) unter Verwendung der Formel PHS_{A}S_{B}(i+1,i)= PHS_{A}S_{B}(i,i)+ PHS_{A}S_{B}(i+1,i+1)-PHS_{A}S_{B}(i,i+1), und Berechnen von PHS_{A}S_{B}(j+2,j) unter Verwendung der Formel PHS_{A}S_{B}(j+2,j)= PHS_{A}S_{B}(j+1,j)+ PHS_{A}S_{B}(j+2,j+1)- PHS_{A}S_{B}(j+1,j+1), Berechnen von PHS_{A}S_{B}(j,j+2) unter Verwendung der Formel PHS_{A}S_{B}(j,j+2)= PHS_{A}S_{B}(j,j+1)+ PHS_{A}S_{B}(j+1,j+2)- PHS_{A}S_{B}(j+1,j+1), wobei j eine Ganzzahl und 1≤j≤n-2 ist, Berechnen von Phasenkalibrierungsparametern zwischen den Kanalsignalen S_{A}, S_{B} jeder der verbleibenden Bereichskombinationen des Weitbereichsmessgeräts (2) Ebene für Ebene;
Schritt S4, Speichern der berechneten Phasenkalibrierungsparameter in dem Speicher; und
Schritt S5, Aufrufen der entsprechenden in dem Speicher gespeicherten Phasenkalibrierungsparameter zur Kalibrierung der Nullphasenpunkte zwischen verschiedenen Signalkanälen des Messgeräts während der Kalibrierung des Weitbereichsmessgeräts.

2. Verfahren nach Anspruch 1, **dadurch gekennzeichnet, dass**
das Verhältnis zwischen dem kleineren Messbereich *Rᵢ₊₁* und dem größeren Messbereich *Rᵢ* der benachbarten Bereichskombinationen (*Rᵢ, Rᵢ₊₁*) des Weitbereichsmessgeräts (2) größer oder gleich 0,1 und kleiner als 1 ist.

3. Verfahren nach Anspruch 2, **dadurch gekennzeichnet, dass**
das Verhältnis zwischen dem kleineren Messbereich *Rᵢ₊₁* und dem größeren Messbereich *Rᵢ* der benachbarten Bereichskombination (*Rᵢ, Rᵢ₊₁*) des Weitbereichsmessgeräts (2) 0,4 oder 0,5 beträgt.

4. Verfahren nach Anspruch 3, **dadurch gekennzeichnet, dass** die Kanalsignale Wechselspannungssignale sind.

5. Verfahren nach Anspruch 3, **dadurch gekennzeichnet, dass** die Kanalsignale Wechselstromsignale sind.

6. Computervorrichtung, die einen Speicher und einen oder mehrere Prozessoren umfasst, wobei computerlesbare Anweisungen in dem Speicher gespeichert sind, wenn die computerlesbaren Anweisungen von dem einen oder den mehreren Prozessoren ausgeführt werden, wobei der eine oder die mehreren Prozessoren dazu ausgelegt sind, die folgenden Schritte durchzuführen:
Schritt S1, Auswählen einer Gruppe von Bereichskombinationen (*Rᵢ, Rᵢ*), bestehend aus einem Messbereich *Rᵢ* eines Kanals A und demselben Messbereich *Rᵢ* eines anderen Kanals B, einer Gruppe von Bereichskombinationen *(R*_{*i*+1} *Rᵢ₊₁),* bestehend aus einem Messbereich *Rᵢ₊₁* des Kanals A und demselben Messbereich *Rᵢ₊₁* des Kanals B, und einer Gruppe benachbarter Bereichskombinationen (*Rᵢ, Rᵢ₊₁*), bestehend aus dem Messbereich *Rᵢ* des Kanals A und einem kleineren Messbereich *Rᵢ₊₁* benachbart zu dem Messbereich *Rᵢ* des Kanals B, für jedes i = 1..n-1, Ausgeben von Signalen mit der vollen Amplitude des kleineren Messbereichs eines Weitbereichsmessgeräts (2) durch eine Standardquelle (3), Messen eines Phasenkalibrierungsparameters PHS_{A}S_{B} (i,i) zwischen den Kanalsignalen S_{A} und S_{B} für die Bereichskombination (*Rᵢ, Rᵢ*), eines Phasenkalibrierungsparameters PHS_{A}S_{B} (i+1,i+1) zwischen den Kanalsignalen S_{A} und S_{B} für die Bereichskombination (*Rᵢ₊₁*, *Rᵢ₊₁*) und eines Phasenkalibrierungsparameters PHS_{A}S_{B} (i,i+1) zwischen den Kanalsignalen S_{A} und S_{B} für die benachbarte Bereichskombination (*Rᵢ, Rᵢ₊₁*);
wobei das Weitbereichsmessgerät (2) mehrere Messbereiche umfasst, die als *R*₁, *R*₂ ,..., *Rₙ* bezeichnet sind, wobei n die Gesamtzahl der Messbereiche ist, und die Messbereiche so angeordnet sind, dass *Rᵢ* einen größeren Messbereich als *R*_{*i*+*1*} darstellt, für i=1...n-1;
Schritt S2, Speichern der Phasenkalibrierungsparameter in einem Speicher;
**dadurch gekennzeichnet, dass** der eine oder die mehreren Prozessoren ferner dazu ausgelegt sind, die folgenden Schritte durchzuführen:
Schritt S3, Aufrufen der in dem Speicher gespeicherten gemessenen Phasenkalibrierungsparameter gemäß der Gleichung PHS_{A}S_{B}(i1,j1) + PHS_{A}S_{B}(i2,j2) = PHS_{A}S_{B}(i1,j2) + PHS_{A}S_{B}(i2,j1), Berechnen von PHS_{A}S_{B}(i+1,i) unter Verwendung der Formel PHS_{A}S_{B}(i+1,i)= PHS_{A}S_{B}(i,i)+ PHS_{A}S_{B}(i+1,i+1)-PHS_{A}S_{B}(i,i+1), und Berechnen von PHS_{A}S_{B}(j+2,j) unter Verwendung der Formel PHS_{A}S_{B}(j+2,j)= PHS_{A}S_{B}(j+1,j)+ PHS_{A}S_{B}(j+2,j+1)- PHS_{A}S_{B}(j+1,j+1), Berechnen von PHS_{A}S_{B}(j,j+2) unter Verwendung der Formel PHS_{A}S_{B}(j,j+2)= PHS_{A}S_{B}(j,j+1)+ PHS_{A}S_{B}(j+1,j+2)- PHS_{A}S_{B}(j+1,j+1), wobei j eine Ganzzahl und 1≤j≤n-2 ist, Berechnen von Phasenkalibrierungsparametern zwischen den Kanalsignalen S_{A}, S_{B} jeder der verbleibenden Bereichskombinationen des Weitbereichsmessgeräts (2) Ebene für Ebene;
Schritt S4, Speichern der berechneten Phasenkalibrierungsparameter in dem Speicher; und
Schritt S5, Aufrufen der entsprechenden, in dem Speicher gespeicherten Phasenkalibrierungsparameter zur Kalibrierung der Nullphasenpunkte zwischen verschiedenen Signalkanälen des Messgeräts während der Kalibrierung des Weitbereichsmessgeräts (2).

7. Computervorrichtung nach Anspruch 6, **dadurch gekennzeichnet, dass**
das Verhältnis zwischen dem kleineren Messbereich *Rᵢ₊₁* und dem größeren Messbereich *Rᵢ* der benachbarten Bereichskombinationen (*Rᵢ, Rᵢ₊₁*) des Weitbereichsmessgeräts (2) größer oder gleich 0,1 und kleiner als 1 ist.

8. Ein oder mehrere nichtflüchtige, computerlerlesbare Speichermedien, die computerlesbare Anweisungen speichern, wobei, wenn die computerlesbaren Anweisungen von einem oder mehreren Prozessoren ausgeführt werden, der oder die Prozessoren dazu ausgelegt sind, die folgenden Schritte durchzuführen:
Schritt S1, Auswählen einer Gruppe von Bereichskombinationen (*Rᵢ, Rᵢ*), bestehend aus einem Messbereich *Rᵢ* eines Kanals A und demselben Messbereich *Rᵢ* eines anderen Kanals B, einer Gruppe von Bereichskombinationen (*R*_{*i*+1}, *Rᵢ₊₁*), bestehend aus einem Messbereich *Rᵢ₊₁* des Kanals A und demselben Messbereich *Rᵢ₊₁* des Kanals B, und einer Gruppe benachbarter Bereichskombinationen (*Rᵢ, Rᵢ₊₁*), bestehend aus dem Messbereich *Rᵢ* des Kanals A und einem kleineren Messbereich *Rᵢ₊₁* benachbart zu dem Messbereich *Rᵢ* des Kanals B, für jedes i = 1..n-1, Ausgeben von Signalen mit der vollen Amplitude des kleineren Messbereichs eines Weitbereichsmessgeräts (2) durch eine Standardquelle (3), Messen eines Phasenkalibrierungsparameters PHS_{A}S_{B} (i,i) zwischen den Kanalsignalen S_{A} und S_{B} für die Bereichskombination (*Rᵢ, Rᵢ*), eines Phasenkalibrierungsparameters PHS_{A}S_{B} (i+1,i+1) zwischen den Kanalsignalen S_{A} und S_{B} für die Bereichskombination (*R*_{*i*+1}, *Rᵢ₊₁*) und eines Phasenkalibrierungsparameters PHS_{A}S_{B} (i,i+1) zwischen den Kanalsignalen S_{A} und S_{B} für die benachbarte Bereichskombination (*Rᵢ, Rᵢ₊₁*);
wobei das Weitbereichsmessgerät (2) mehrere Messbereiche umfasst, die als *R*₁, *R*₂ ,..., *Rₙ* bezeichnet sind, wobei n die Gesamtzahl der Messbereiche ist, und die Messbereiche so angeordnet sind, dass *Rᵢ* einen größeren Messbereich als *Rᵢ₊₁* darstellt, für i=1...n-1;
Schritt S2, Speichern der Phasenkalibrierungsparameter in einem Speicher;
**dadurch gekennzeichnet, dass** der eine oder die mehreren Prozessoren ferner dazu ausgelegt sind, die folgenden Schritte durchzuführen:
Schritt S3, Aufrufen der in dem Speicher gespeicherten gemessenen Phasenkalibrierungsparameter gemäß der Gleichung PHS_{A}S_{B}(i1,j1) + PHS_{A}S_{B}(i2,j2) = PHS_{A}S_{B}(i1,j2) + PHS_{A}S_{B}(i2,j1), Berechnen von PHS_{A}S_{B}(i+1,i) unter Verwendung der Formel PHS_{A}S_{B}(i+1,i)= PHS_{A}S_{B}(i,i)+ PHS_{A}S_{B}(i+1,i+1)-PHS_{A}S_{B}(i,i+1), und Berechnen von PHS_{A}S_{B}(j+2,j) unter Verwendung der Formel PHS_{A}S_{B}(j+2,j)= PHS_{A}S_{B}(j+1,j)+ PHS_{A}S_{B}(j+2,j+1)- PHS_{A}S_{B}(j+1,j+1), Berechnen von PHS_{A}S_{B}(j,j+2) unter Verwendung der Formel PHS_{A}S_{B}(j,j+2)= PHS_{A}S_{B}(j,j+1)+ PHS_{A}S_{B}(j+1,j+2)- PHS_{A}S_{B}(j+1,j+1), wobei j eine Ganzzahl und 1≤j≤n-2 ist, Berechnen von Phasenkalibrierungsparametern zwischen den Kanalsignalen S_{A}, S_{B} jeder der verbleibenden Bereichskombinationen des Weitbereichsmessgeräts (2) Ebene für Ebene;
Schritt S4, Speichern der berechneten Phasenkalibrierungsparameter in dem Speicher; und
Schritt S5, Aufrufen der entsprechenden, in dem Speicher gespeicherten Phasenkalibrierungsparameter zur Kalibrierung der Nullphasenpunkte zwischen verschiedenen Signalkanälen des Messgeräts während der Kalibrierung des Weitbereichsmessgeräts (2).

9. Speichermedium nach Anspruch 8, **dadurch gekennzeichnet, dass**
das Verhältnis zwischen dem kleineren Messbereich *Rᵢ₊₁* und dem größeren Messbereich *Rᵢ* der benachbarten Bereichskombinationen (*Rᵢ, Rᵢ₊₁*) des Weitbereichsmessgeräts (2) größer oder gleich 0,1 und kleiner als 1 ist.

## Revendications

1. Procédé d'étalonnage à phase nulle pour l'étalonnage de points à phase nulle entre différents canaux de signaux d'un compteur à plage large (2), dans lequel le compteur à plage large (2) comporte une pluralité de plages de mesure désignées par *R*₁, *R*₂, ..., *Rₙ*, dans lequel n est le nombre total de plages de mesure, et les plages de mesure sont ordonnées de sorte que *Rᵢ* représente une plage de mesure plus grande que R_{*i*+1}, pour i = 1 ... n-1 ;
dans lequel le procédé inclut :
étape S1, la sélection d'un groupe de combinaisons de plages (*Rᵢ, Rᵢ*) consistant en une plage de mesure *Rᵢ* d'un canal A et la même plage de mesure *Rᵢ* d'un autre canal B, d'un groupe de combinaisons de plages (*R*_{*i*+1}, *R*_{*i*+1}) consistant en une plage de mesure *R*_{*i*+1} du canal A et la même plage de mesure *R*_{*i*+1} du canal B et d'un groupe de combinaisons de plages adjacentes (*Rᵢ, R*_{*i+*1}) consistant en la plage de mesure *Rᵢ* du canal A et une plage de mesure plus petite *R*_{*i*+1} adjacente à la plage de mesure *Rᵢ* du canal B, pour chaque i = 1 .. n-1, la sortie de signaux dotés de l'amplitude pleine échelle de la plage de mesure plus petite du compteur à plage large (2) par une source standard (3), la mesure d'un paramètre d'étalonnage de phase PHS_{A}S_{B}(i,i) entre les signaux de canal S_{A} et S_{B} pour la combinaison de plages (*Rᵢ, Rᵢ*), d'un paramètre d'étalonnage de phase PHS_{A}S_{B}(i+1,i+1) entre les signaux de canal S_{A} et S_{B} pour la combinaison de plages (*R*_{*i*+1}, *R*_{*i*+1}) et un paramètre d'étalonnage de phase PHS_{A}S_{B}(i,i+1) entre les signaux de canal S_{A} et S_{B} pour la combinaison de plages adjacente (*Rᵢ, R*_{*i+*1}) ;
étape S2, le stockage des paramètres d'étalonnage de phase dans une mémoire ;
**caractérisé en ce que** le procédé inclut en outre :
étape S3, l'appel des paramètres d'étalonnage de phase mesurés stockés dans la mémoire, selon l'équation PHS_{A}S_{B}(i1,j1) + PHS_{A}S_{B}(i2,j2) = PHS_{A}S_{B}(i1,j2) + PHS_{A}S_{B}(i2,j1), le calcul de PHS_{A}S_{B}(i+1,i) en utilisant la formule PHS_{A}S_{B}(i+1,i) = PHS_{A}S_{B}(i,i) + PHS_{A}S_{B}(i+1,i+1) - PHS_{A}S_{B}(i,i+1), et le calcul de PHS_{A}S_{B}(j+2,j) en utilisant la formule PHS_{A}S_{B}(j+2,j) = PHS_{A}S_{B}(j+1,j) + PHS_{A}S_{B}(j+2,j+1) - PHS_{A}S_{B}(j+1,j+1), le calcul de PHS_{A}S_{B}(j,j+2) en utilisant la formule PHS_{A}S_{B}(j,j+2) = PHS_{A}S_{B}(j,j+1) + PHS_{A}S_{B}(j+1,j+2) - PHS_{A}S_{B}(j+1,j+1), dans lequel j est un nombre entier et 1 ≤ j ≤ n-2, le calcul de paramètres d'étalonnage de phase entre les signaux de canal S_{A}, S_{B} de chacune des combinaisons de plages restantes du compteur à plage large (2) niveau par niveau ;
étape S4, le stockage des paramètres d'étalonnage de phase calculés dans la mémoire ; et
étape S5, l'appel de paramètres d'étalonnage de phase correspondants stockés dans la mémoire pour étalonner les points à phase nulle entre différents canaux de signaux du compteur tout en étalonnant le compteur à plage large.

2. Procédé selon la revendication 1, **caractérisé en ce que**
le rapport entre la plage de mesure plus petite *Rᵢ₊₁* et la plage de mesure plus grande *Rᵢ* des combinaisons de plages adjacentes (*Rᵢ, Rᵢ₊₁*) du compteur à plage large (2) est supérieur ou égal à 0,1 et inférieur à 1.

3. Procédé selon la revendication 2, **caractérisé en ce que**,
le rapport entre la plage de mesure plus petite *Rᵢ₊₁* et la plage de mesure plus grande *Rᵢ* des combinaisons de plages adjacentes (*Rᵢ, Rᵢ₊₁*) du compteur à plage large (2) est de 0,4 ou 0,5.

4. Procédé selon la revendication 3, **caractérisé en ce que** les signaux de canal sont des signaux de tension alternative.

5. Procédé selon la revendication 3, **caractérisé en ce que** les signaux de canal sont des signaux de courant alternatif.

6. Dispositif informatique comportant une mémoire et un ou plusieurs processeurs, dans lequel des instructions lisibles par ordinateur sont stockées dans la mémoire, lorsque les instructions lisibles par ordinateur sont exécutées par lesdits un ou plusieurs processeurs, lesdits un ou plusieurs processeurs sont amenés à mettre en œuvre les étapes suivantes :
étape S1, la sélection d'un groupe de combinaisons de plages (*Rᵢ, Rᵢ*) consistant en une plage de mesure *Rᵢ* d'un canal A et la même plage de mesure *Rᵢ* d'un autre canal B, d'un groupe de combinaisons de plages (*R*_{*i*+1}, *R*_{*i*+1}) consistant en une plage de mesure *R*_{*i*+1} du canal A et la même plage de mesure *R*_{*i*+1} du canal B et d'un groupe de combinaisons de plages adjacentes (*Rᵢ, R*_{*i*+1}) consistant en la plage de mesure *Rᵢ* du canal A et une plage de mesure plus petite *Rᵢ₊₁* adjacente à la plage de mesure *Rᵢ* du canal B, pour chaque i = 1 .. n-1, la sortie de signaux dotés de l'amplitude pleine échelle de la plage de mesure plus petite d'un compteur à plage large (2) par une source standard (3), la mesure d'un paramètre d'étalonnage de phase PHS_{A}S_{B}(i,i) entre les signaux de canal S_{A} et S_{B} pour la combinaison de plages (*Rᵢ, Rᵢ*), d'un paramètre d'étalonnage de phase PHS_{A}S_{B}(i+1,i+1) entre les signaux de canal S_{A} et S_{B} pour la combinaison de plages (*R*_{*i*+1}, *R*_{*i*+1}) et un paramètre d'étalonnage de phase PHS_{A}S_{B}(i,i+1) entre les signaux de canal S_{A} et S_{B} pour la combinaison de plages adjacente (*Rᵢ, R*_{*i*+1}) ;
dans lequel le compteur à plage large (2) comporte une pluralité de plages de mesure désignées par *R*₁, *R*₂, ..., *Rₙ*, dans lequel n est le nombre total de plages de mesure, et les plages de mesure sont ordonnées de sorte que *Rᵢ* représente une plage de mesure plus grande que R_{*i*+1}, pour i = 1 ... n-1 ;
étape S2, le stockage des paramètres d'étalonnage de phase dans une mémoire ;
**caractérisé en ce que** les un ou plusieurs processeurs sont en outre amenés à mettre en œuvre les étapes suivantes :
étape S3, l'appel des paramètres d'étalonnage de phase mesurés stockés dans la mémoire, selon l'équation PHS_{A}S_{B}(i1,j1) + PHS_{A}S_{B}(i2,j2) = PHS_{A}S_{B}(i1,j2) + PHS_{A}S_{B}(i2,j1), le calcul de PHS_{A}S_{B}(i+1,i) en utilisant la formule PHS_{A}S_{B}(i+1,i) = PHS_{A}S_{B}(i,i) + PHS_{A}S_{B}(i+1,i+1) - PHS_{A}S_{B}(i,i+1), et le calcul de PHS_{A}S_{B}(j+2,j) en utilisant la formule PHS_{A}S_{B}(j+2,j) = PHS_{A}S_{B}(j+1,j) + PHS_{A}S_{B}(j+2,j+1) - PHS_{A}S_{B}(j+1,j+1), le calcul de PHS_{A}S_{B}(j,j+2) en utilisant la formule PHS_{A}S_{B}(j,j+2) = PHS_{A}S_{B}(j,j+1) + PHS_{A}S_{B}(j+1,j+2) - PHS_{A}S_{B}(j+1,j+1), dans lequel j est un nombre entier et 1 ≤ j ≤ n-2, le calcul de paramètres d'étalonnage de phase entre les signaux de canal S_{A}, S_{B} de chacune des combinaisons de plages restantes du compteur à plage large (2) niveau par niveau ;
étape S4, le stockage des paramètres d'étalonnage de phase calculés dans la mémoire ; et
étape S5, l'appel de paramètres d'étalonnage de phase correspondants stockés dans la mémoire pour étalonner les points à phase nulle entre différents canaux de signaux du compteur tout en étalonnant le compteur à plage large (2).

7. Dispositif informatique selon la revendication 6, **caractérisé en ce que**,
le rapport entre la plage de mesure plus petite *R*_{*i*+1} et la plage de mesure plus grande *Rᵢ* des combinaisons de plages adjacentes (*Rᵢ, R*_{*i*+1}) du compteur à plage large (2) est supérieur ou égal à 0,1 et inférieur à 1.

8. Un ou plusieurs supports de stockage non transitoires lisibles par ordinateur stockant des instructions lisibles par ordinateur, dans lequel ou lesquels, lorsque les instructions lisibles par ordinateur sont exécutées par un ou plusieurs processeurs, lesdits un ou plusieurs processeurs sont amenés à mettre en œuvre les étapes suivantes :
étape S1, la sélection d'un groupe de combinaisons de plages (*Rᵢ, Rᵢ*) consistant en une plage de mesure *Rᵢ* d'un canal A et la même plage de mesure *Rᵢ* d'un autre canal B, d'un groupe de combinaisons de plages (*R*_{*i*+1}, *R*_{*i*+1}) consistant en une plage de mesure *R*_{*i*+1} du canal A et la même plage de mesure *R*_{*i*+1} du canal B et d'un groupe de combinaisons de plages adjacentes (*Rᵢ, R*_{*i*+1}) consistant en la plage de mesure *Rᵢ* du canal A et une plage de mesure plus petite *R*_{*i*+1} adjacente à la plage de mesure *Rᵢ* du canal B, pour chaque i = 1 .. n-1, la sortie de signaux dotés de l'amplitude pleine échelle de la plage de mesure plus petite d'un compteur à plage large (2) par une source standard (3), la mesure d'un paramètre d'étalonnage de phase PHS_{A}S_{B}(i,i) entre les signaux de canal S_{A} et S_{B} pour la combinaison de plages (*Rᵢ, Rᵢ*), d'un paramètre d'étalonnage de phase PHS_{A}S_{B}(i+1,i+1) entre les signaux de canal S_{A} et S_{B} pour la combinaison de plages (*R*_{*i*+1}, *R*_{*i*+1}) et un paramètre d'étalonnage de phase PHS_{A}S_{B}(i,i+1) entre les signaux de canal S_{A} et S_{B} pour la combinaison de plages adjacente (*Rᵢ, Rᵢ₊₁*) ;
dans lequel le compteur à plage large (2) comporte une pluralité de plages de mesure désignées par *R*₁, *R*₂, ..., *Rₙ*, dans lequel n est le nombre total de plages de mesure, et les plages de mesure sont ordonnées de sorte que *Rᵢ* représente une plage de mesure plus grande que R_{*i*+1}, pour i = 1 ... n-1 ;
étape S2, le stockage des paramètres d'étalonnage de phase dans une mémoire ;
**caractérisé en ce que** les un ou plusieurs processeurs sont en outre amenés à mettre en œuvre les étapes suivantes :
étape S3, l'appel des paramètres d'étalonnage de phase mesurés stockés dans la mémoire, selon l'équation PHS_{A}S_{B}(i1,j1) + PHS_{A}S_{B}(i2,j2) = PHS_{A}S_{B}(i1,j2) + PHS_{A}S_{B}(i2,j1), le calcul de PHS_{A}S_{B}(i+1,i) en utilisant la formule PHS_{A}S_{B}(i+1,i) = PHS_{A}S_{B}(i,i) + PHS_{A}S_{B}(i+1,i+1) - PHS_{A}S_{B}(i,i+1), et le calcul de PHS_{A}S_{B}(j+2,j) en utilisant la formule PHS_{A}S_{B}(j+2,j) = PHS_{A}S_{B}(j+1,j) + PHS_{A}S_{B}(j+2,j+1) - PHS_{A}S_{B}(j+1,j+1), le calcul de PHS_{A}S_{B}(j,j+2) en utilisant la formule PHS_{A}S_{B}(j,j+2) = PHS_{A}S_{B}(j,j+1) + PHS_{A}S_{B}(j+1,j+2) - PHS_{A}S_{B}(j+1,j+1), dans lequel j est un nombre entier et 1 ≤ j ≤ n-2, le calcul de paramètres d'étalonnage de phase entre les signaux de canal S_{A}, S_{B} de chacune des combinaisons de plages restantes du compteur à plage large (2) niveau par niveau ;
étape S4, le stockage des paramètres d'étalonnage de phase calculés dans la mémoire ; et
étape S5, l'appel de paramètres d'étalonnage de phase correspondants stockés dans la mémoire pour étalonner les points à phase nulle entre différents canaux de signaux du compteur tout en étalonnant le compteur à plage large (2).

9. Support de stockage selon la revendication 8, **caractérisé en ce que**,
le rapport entre la plage de mesure plus petite *R*_{*i*+1} et la plage de mesure plus grande *Rᵢ* des combinaisons de plages adjacentes (*Rᵢ, R*_{*i*+1}) du compteur à plage large (2) est supérieur ou égal à 0,1 et inférieur à 1.
